# EUROPEAN PATENT APPLICATION

(11) **EP 4 832 669 A1**
(43) Date of publication of application: **28.10.2026**
(21) Application number: 26174230.8
(22) Date of filing: 23.04.2026
(51) Int. Cl.: H05K 1/02, H05K 3/341

(54) **HIGH-SPEED BALL GRID ARRAY (BGA) USING MINIMUM BGA MATRIX SIZE**

(30) Priority: 24.04.2025 US 202519188151
(71) Applicant: Google LLC, Mountain View, CA 94043 (US)
(72) Inventor: Altman, Shai Sayfan, Tel-Aviv-Yafo (IL); Malka, Nir, 3508409 Haifa (IL); Shkolnik, Alexander, 3508409 Haifa (IL)
(74) Representative: Betten & Resch

(57) **Abstract**

Generally disclosed herein is an approach for improving signal integrity by inserting an additional via between package core vias that are not in ball grid arrays (BGAs) to isolate signal groups and reduce the signal interference in the BGA package. The approach may decrease the available number of solder balls on the package side since no extra ground barriers are needed to separate channels to prevent noise signals. The approach also includes organizing locations of vias with varying lengths to improve signal integrity on a printed circuit board (PCB) side. For example, a first interconnect between a first input/output (IO) device mounted on the PCB and a second IO device mounted on the PCB is routed on a layer that is far apart from another layer in which a second interconnect between a third IO device and a fourth IO device is routed.

## Description

A ball grid array (BGA) package is a type of package for integrated circuits having numerous interconnects. BGA packages include several electrical contacts in the form of solder balls on the bottom side for providing electrical connections between the integrated circuits and a printed circuit board (PCB) on which the BGA package is mounted. As high-speed interface connections are widely used today, maintaining the signal integrity of the BGA package has become increasingly important.

Signal integrity refers to the quality of an electrical signal transferring between the integrated circuits of the BGA package and the PCB. The signals can be affected when one signal interferes with a different signal, causing signal quality degradation, which can lead to the mis-transfer of data between the integrated circuits of the BGA package and the PCB. Inserting extra ground BGAs between the BGA interconnects can isolate the noise signals from neighboring signals to maintain signal integrity. However, adding extra ground BGAs may increase manufacturing costs and the package's overall size.

### SUMMARY

Generally disclosed herein is an approach for improving signal integrity by inserting an additional via between package core vias that are not in ball grid arrays (BGAs) to isolate signal groups and reduce signal interferences in the BGA package. The approach may decrease the available number of solder balls on the package side since no extra ground barriers are needed to separate channels to prevent noise signals. The approach also includes organizing locations of vias with varying lengths to improve signal integrity on a printed circuit board (PCB) side. For example, a first interconnect between a first input/output (IO) device mounted on the PCB and a second IO device mounted on the PCB is routed on a layer that is far apart from another layer in which a second interconnect between a third IO device and a fourth IO device is routed.

An aspect of the disclosure provides a printed circuit board (PCB) comprising a substrate, a plurality of layers disposed in the substrate, and a plurality of vias extending through the plurality of layers connecting two or more layers, wherein each via of the plurality of vias is arranged in a predefined order based on a length of that via, wherein the plurality of vias connect through an interconnect to a set of solder balls on an integrated circuit package.

In some examples, the plurality of layers may facilitate signal transfer between input/output (I/O) devices mounted on the PCB.

In some examples, each via of the plurality of vias may have a counterpart via, wherein the I/O devices mounted on the PCB may be configured to communicate through a corresponding layer of the plurality of layers that each via and its counterpart via are configured to reach.

In some examples, each via of the plurality of vias may have a different length.

In some examples, each via of the plurality of vias may be configured to extend through a different number of layers of the plurality of layers.

In some examples, the plurality of vias may include a first via with a longest length configured to be adjacent to a second via with a shortest length.

In some examples, the plurality of vias may include a third via with a second longest length configured to be located farthest from the first via with the longest length.

In some examples, the plurality of vias does not include ground walls between each other.

In some examples, the integrated circuit package may comprise a substrate having a first side and a second side opposite the first side, an integrated circuit component coupled to the second side of the substrate, and a ball grid array (BGA) formed on the first side of the substrate, the ball grid array comprising a plurality of solder balls.

In some examples, the integrated circuit package may comprise one or more channels.

In some examples, each of the one or more channels may include a plurality of subchannels.

In some examples, each subchannel of the plurality of subchannels may include a respective via.

In some examples, the respective via included in each sub-channel of the plurality of sub-channels may have a different length than vias included in other sub-channels.

In some examples, the one or more channels may be separated by an array of solder balls.

In some examples, the one or more channels may be connected to different layers inside the PCB.

Another aspect of the disclosure provides a system comprising a printed circuit board (PCB) including a plurality of vias extending through a plurality of layers connecting two or more layers, wherein each via of the plurality of vias is arranged in a predefined order based on a length of that via, and one or more integrated circuit packages connected to the PCB through a plurality of interfaces between a plurality of solder balls included in the one or more integrated circuit packages.

In some examples, each via of the plurality of vias may be configured to extend through a different number of layers of the plurality of layers.

In some examples, the plurality of vias does not include ground walls between each other.

In some examples, the plurality of vias may include a first via with a longest length configured to be adjacent to a second via with a shortest length.

Yet another aspect of the disclosure provides a method for isolating crosstalk between adjacent vias. The method may comprise providing a PCB with a plurality of vias, arranging the plurality of vias in a predefined order based on lengths, wherein the plurality of vias extend through a plurality of layers within the PCB connecting two or more layers, wherein each via of the plurality of vias is arranged in a predefined order based on a length of that via, and connecting a plurality of devices using the plurality of vias.

### BRIEF DESCRIPTION OF THE DRAWINGS

FIG. 1 is a schematic representation of a conventional arrangement of multiple vias.
FIG. 2 is a schematic representation of a conventional arrangement of ball grid arrays (BGAs) disposed on a bottom side of an integrated circuit package.
FIG. 3 is a schematic representation of an example arrangement of multiple vias without using ground walls in accordance with aspects of the disclosure.
FIG. 4 is a schematic representation of an example arrangement of BGAs without using ground barriers in accordance with aspects of the disclosure.
FIG. 5 is a schematic representation of various vias extending through different levels of layers in accordance with aspects of the disclosure.
FIG. 6 is a flow diagram of an example process for isolating crosstalk between adjacent vias in accordance with aspects of the disclosure.
FIG. 7 is a block diagram of an example computing environment for implementing an integrated circuit in accordance with aspects of the disclosure.

### DETAILED DESCRIPTION

The present disclosure relates to an approach for improving signal integrity between an integrated circuit (IC) package and a printed circuit board (PCB) based on reducing crosstalk between adjacent vias. The approach includes at least two approaches. The first approach is to improve signal integrity by inserting additional vias between IC package's core vias. The IC package's core vias may include vias that connect the different layers of the IC substrate or interposer. The second approach is to isolate signal groups and reduce the signal interference by isolating the different groups of vias to create a minimum amount of overlapping between the vias in a PCB by having a short via near a long via, thereby eliminating space for additional ground barriers to separate channels.

Conventionally, the number of the required vias usually matches the exact number of BGA balls that are in a BGA matrix. While adding additional ground vias in the IC package may help reduce crosstalk between the adjacent BGAs, the increased number of the BGA balls may result in a larger IC package size. By removing the extra ground barriers and placing short vias near long vias, the crosstalk between the different groups of vias may be reduced, and the size of both the IC package and the PCB may also be reduced.

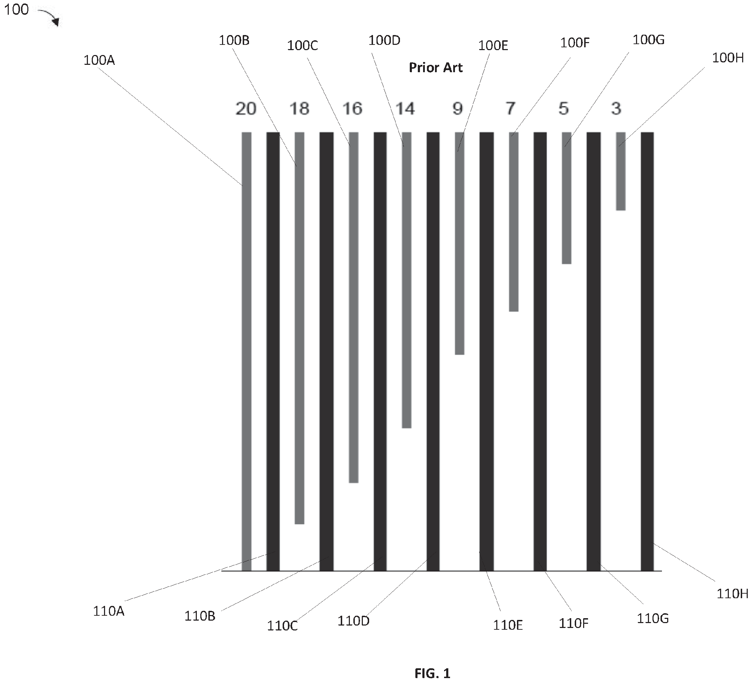

FIG. 1 is a schematic representation of a conventional implementation of vias in varying lengths. PCB 100 may include vias 100A-H. Vias may refer to an electrical connection between two or more metal layers. Each via of vias 100A-H may have different lengths and be arranged in decreasing order of length from left-hand side to right-hand side. PCB 100 may include ground walls 110A-H between every two vias. Ground walls may refer to ground vias creating a barrier or a fence around circuitry to mitigate electromagnetic interference (EMI) or crosstalk between adjacent vias. The ground walls are typically composed of conductive materials such as copper. For example, ground wall 110A may mitigate EMI or crosstalk between vias 100A and 100B. In the conventional arrangement of multiple vias, the overall size of PCB 100 increases due to the space required for multiple ground walls.

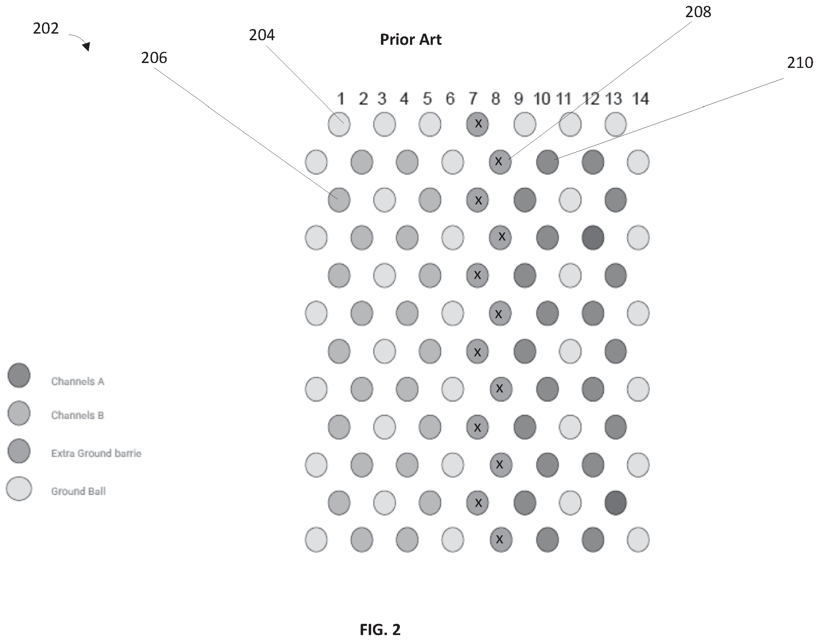

FIG. 2 is a bottom view of a conventional arrangement of ball grid arrays (BGAs) disposed on the bottom side of an integrated circuit package 202 (hereinafter referred to as "package"). Package 202 may be mounted on a PCB such as PCB 100 as depicted in FIG. 1. Package 202 may include a number of electrical contacts on the bottom side for providing electrical connections between the integrated circuit and a PCB on which the package 202 is mounted. The contacts may take the form of solder balls or contact balls on copper pads on the bottom side of the package 202. The contact balls can supply voltage and power to the integrated circuit and provide paths for electrical signals traveling to and from the integrated circuit to the PCB. Package 202 may have numerous ground balls, such as ground ball 204. Ground ball 204 may include the contact balls that are connected to a PCB and transmit electrical signals to the PCB. Each groundball is separated by sub-channels, such as channel 206 and channel 210. Channels may refer to gaps or spaces between rows or columns of the solder balls that are intentionally left open on the package. Channels may also refer to specific areas or pathways where vias can be placed to provide routing of electrical signals from the package to the PCB. Ground balls, such as ground ball 204, may be configured to separate the signals transmitted from within channel 206, and ground ball 208 may be configured to separate the two channels, channel 206 and channel 210. In the example of FIG.2, there are two channels: channels A and channels B. Channels A may include a group of sub-channels, such as channels 206. Each sub-channel in channels A may be connected to one or more similar types of IO devices mounted on the PCB. Each channel may include sub-channels having the exact same via lengths as all of the sub-channels of each channel are routed on the same PCB layer. Different channels may have different via lengths as they are routed on different PCB layers. Channels A and channels B are separated by ground barriers such as ground barrier 208. Ground barriers may refer to a row or regions of ground balls intentionally placed to isolate or shield crosstalk between two different vias or sub-channels or reduce noise. In this example, ground barriers may be placed between channels A and channels B. Because of the space needed for ground barriers such as ground barrier 208, the overall size of the package 202 can be increased.

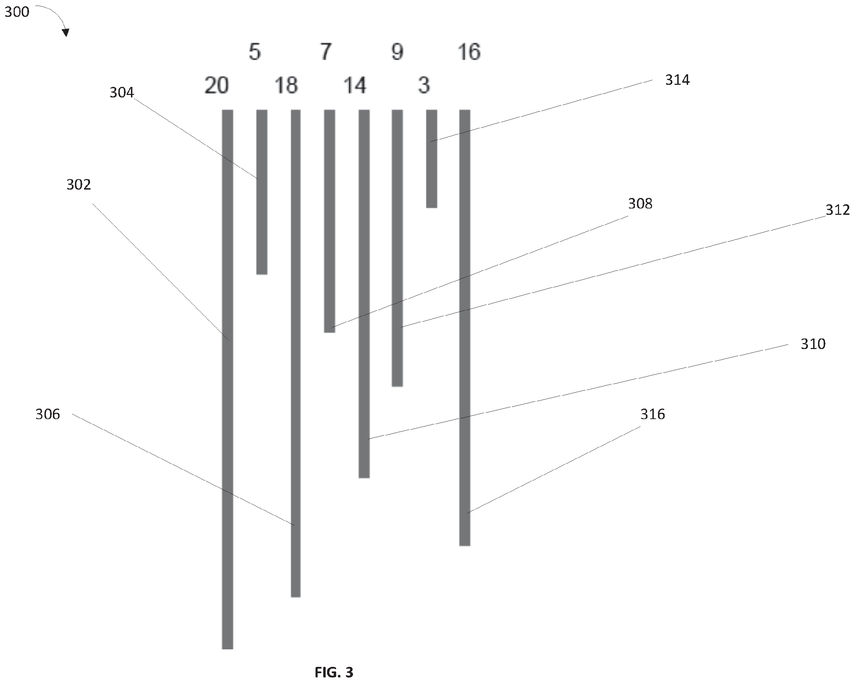

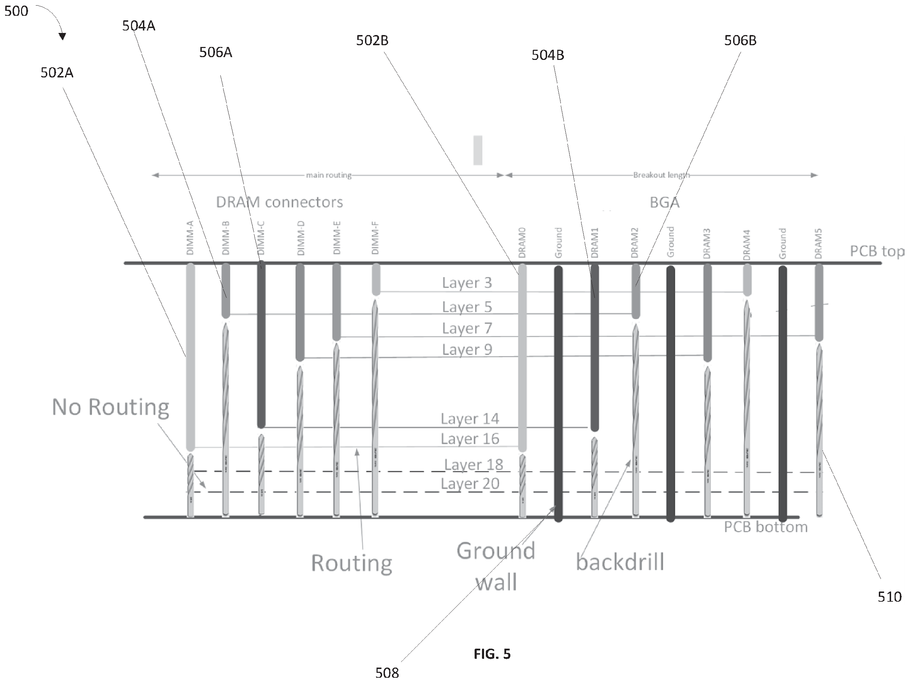

FIG. 3 is a schematic representation of an example arrangement of multiple vias in a PCB without using ground walls. PCB 300 may include multiple vias of varying lengths, such as vias 302-316. Each via of vias 302-316 may extend through a different level of layers to facilitate signal paths between different input/output (IO) devices mounted on the PCB (not shown). The overlapping area between adjacent vias is minimized to reduce the signal noise between two neighboring vias. If the first via is the longest via, then the neighboring via is configured to be the shortest. For example, if the first via is configured to reach up to layer 20, the second via is configured to reach up to layer 3. If the third via is configured to reach up to layer 18, the fourth via is configured to reach up to layer 5. Each via has a counterpart via with the same length (not shown), such that two coupled devices may only communicate through the corresponding layer as described in more detail in connection with FIG.5 below.

According to some examples, PCB 300 may include vias arranged in a zigzag pattern of decreasing and increasing lengths or arranged by alternating between the next longest and next shortest vias. For example, via 302 is the longest via, and via 304 is the second shortest via. In some examples, via 302 may be placed adjacent to the shortest via. The second shortest via 304 may be placed in between the longest via 302 and the second longest via 306. The overlapping area between via 304 and 302 and the overlapping area between via 304 and 306 are minimized by placing the second shortest via 304 in between via 302 and via 306. The shortest via 314 may be placed in between the third longest via 316 and the fourth longest via 312 such that the overlapping area between via 314 and via 316 or the overlapping area between via 314 and via 312 may be minimized. PCB 300 may be implemented without using any ground walls, such as ground walls 110A-H, as depicted in FIG. 1, since the noise or crosstalk between adjacent vias is already reduced by the arrangements of vias as described above. Manufacturers may utilize the space saved by removing the ground walls to place additional vias according to the manufacturer's preference.

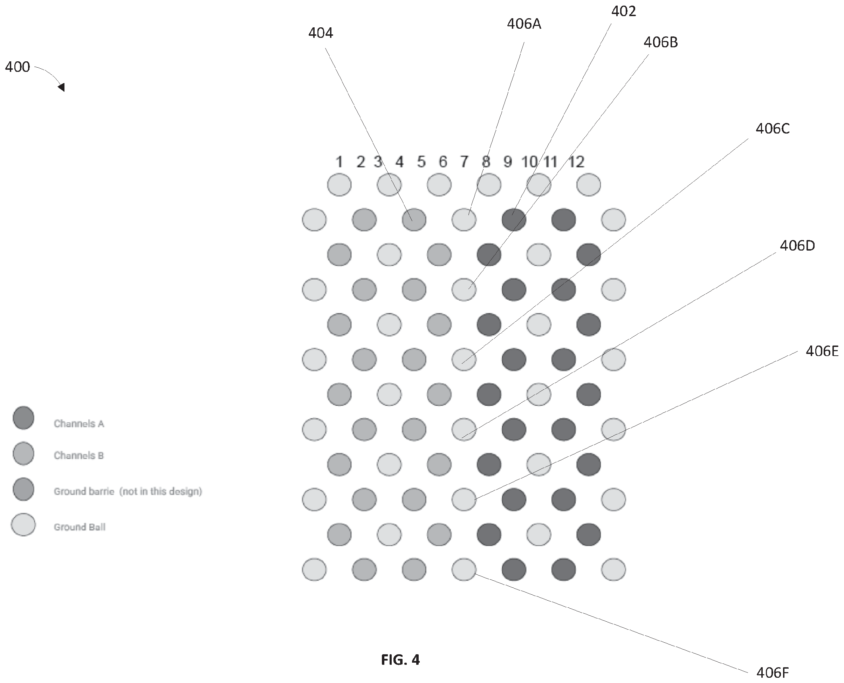

FIG. 4 is a schematic representation of an example arrangement of BGAs in an integrated circuit package 400 without using ground barriers. Channels A may include sub-channels such as channel 402. As described above, channels may refer to a linear gap or space between rows or columns of solder balls on the package, allowing placement of vias inside. Each channel, such as channel 402, may be connected to one of the vias 302-316 depicted in FIG. 3. Sub-channels included in channels A may have identical lengths of vias. Ground balls placed between channels A and channels B may include ground balls 406A-F. Ground balls 406A-F are the same ground balls as the ground balls included in each channel. In contrast to FIG.2, extra ground barriers may be removed since the crosstalk between two sub-channels is already mitigated by reducing the overlapping area between vias, including in each channels A and channels B, using the unique arrangement of vias with varying lengths as described above.

FIG. 5 is a schematic representation of various vias extending through different levels of layers. PCB 500 may include multiple vias of varying lengths, such as vias 502A-B, 504A-B, and 506A-B. Each via may be connected to an individual IO device mounted on PCB 500. For example, via 502A may be connected to a dual in-line memory module-A (DIMM-A), and via 502B may be connected to a processor or system on-chip (SOC). DIMM-A and the SOC may be communicatively coupled through layer 16. Similarly, via 506A and via 504B may be connected to DIMM-C and the SOC, respectively, and communicatively coupled through layer 14. Via 502A may be placed adjacent to short via 504A. Since via 504A is short relative to via 502A and may only reach up to layer 5, while via 502A may reach up to layer 16, the crosstalk between the signal paths of layer 5 and layer 16 is minimal. Likewise, the crosstalk between the signals traveling through layer 14 and layer 5 is minimal, as the overlapping area between vias 506A and 504A or 504B and 506B is small. Ground wall 508 must be inserted between vias 502B and via 504B since the difference in the lengths of both vias is not significant, and thus ground wall 508 may be used to reduce the crosstalk between the signals traveling through layer 16 and layer 14. In some examples, ground wall 508 can be removed if via 502 B is placed adjacent to a via that is shorter than via 504 B to minimize the overlapping area. Backdrills such as backdrill 510 may be used to remove the unused portion of via or the stub of a through-hole via that extends past the layer that each via is reaching.

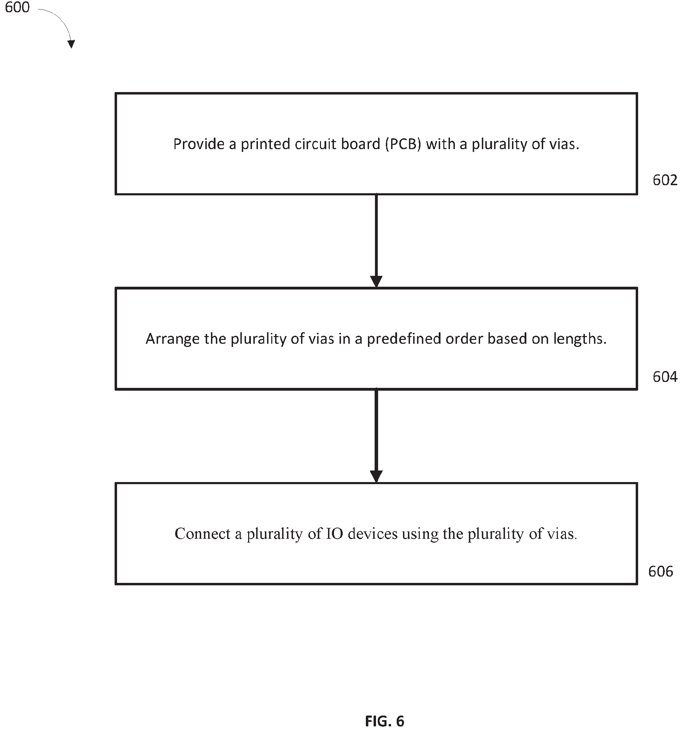

FIG. 6 is a flow diagram of an example process 600 for isolating crosstalk between adjacent vias. According to block 602, process 600 includes providing a PCB with a plurality of vias. Each via has a different length from other vias. Each via can be configured to extend through a different level of layers to facilitate signal paths between different IO devices mounted on the PCB,

According to block 604, process 600 includes arranging the plurality of vias in a predefined order based on length. Process 600 may minimize the overlapping area between adjacent vias to reduce the signal noise between two neighboring vias. For example, the longest via should be placed next to the shortest via.

According to block 606, process 600 includes connecting a plurality of IO devices using the plurality of vias. As described in FIG.5, Each via may be connected to an individual IO device mounted on the PCB, and two IO devices may be communicatively coupled to a signal path formed in a particular layer of the PCB using a pair of vias of the same length. Process 600 may not require the space required for ground walls since the potential crosstalk between two adjacent vias is minimized in accordance with the process described above.

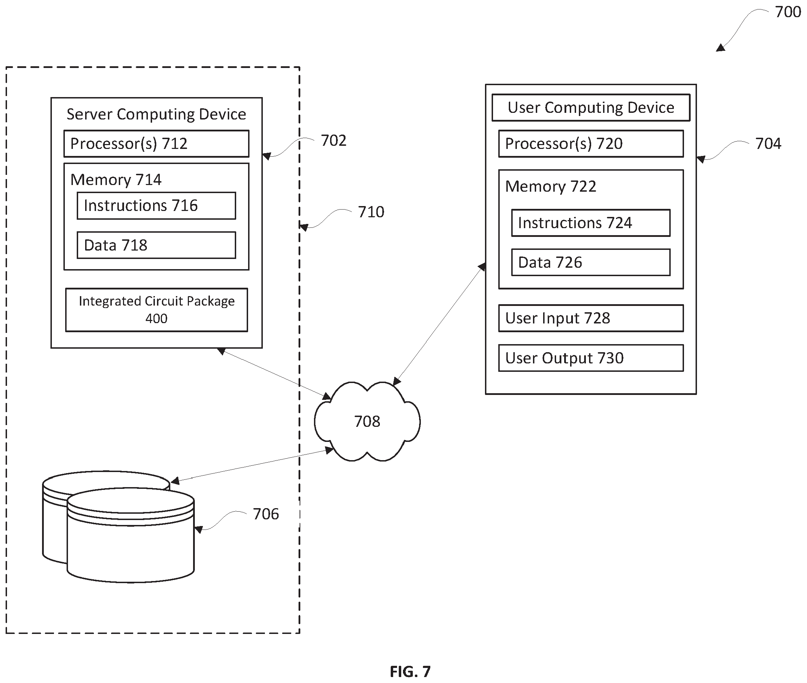

FIG. 7 is a block diagram of an example computing environment for implementing an integrated circuit. FIG. 7 depicts a block diagram of an example computing environment 700 for implementing an integrated circuit, such as the integrated circuit package 400 with the BGAs without using ground barriers as depicted in FIG. 4. The integrated circuit package 400 can be implemented in a device, such as in a server computing device 702. A user computing device 704 and the server computing device 702 can be communicatively coupled to one or more storage devices 706 over a network 708. The server computing device 702 and storage devices 706 can form part of a computing platform 710. The computing platform 710 can be a cloud computing platform, offering a variety of different services, for example for providing compute and storage resources to users of the platform.

The storage devices 706 can be a combination of volatile and non-volatile memory and can be at the same or different physical locations than the computing devices 702, 704. For example, the storage devices 706 can include any type of non-transitory computer readable medium capable of storing information, such as a hard-disk drive (HDD), solid state drive (SSD), tape drive, optical storage, memory card, ROM, RAM, DVD, CD-ROM, write-capable, and read-only memories.

The server computing device 702 can include one or more processors 712 and memory 714. The memory 714 can store information accessible by the processors 712, including instructions 716 that can be executed by the processors 712. The memory 714 can also include data 718 that can be retrieved, manipulated, or stored by the processor 712. The memory 714 can be a type of non-transitory computer readable medium capable of storing information accessible by the processors 712, such as volatile and non-volatile memory. The processors 712 can include one or more central processing units (CPUs), graphic processing units (GPUs), field-programmable gate arrays (FPGAs), and/or application-specific integrated circuits (ASICs), such as tensor processing units (TPUs).

The instructions 716 can include one or more instructions that when executed by the processors 712, cause the one or more processors to perform actions defined by the instructions. The instructions 716 can be stored in object code format for direct processing by the processors 712, or in other formats including interpretable scripts or collections of independent source code modules that are interpreted on demand or compiled in advance.

The data 718 can be retrieved, stored, or modified by the processors 712 in accordance with the instructions 716. The data 718 can be stored in computer registers, in a relational or non-relational database as a table having a plurality of different fields and records, or as JSON, YAML, proto, or XML documents. The data 718 can also be formatted in a computer-readable format such as, but not limited to, binary values, ASCII, or Unicode. Moreover, the data 718 can include information sufficient to identify relevant information, such as numbers, descriptive text, proprietary codes, pointers, references to data stored in other memories, including other network locations, or information that is used by a function to calculate relevant data.

The user computing device 704 can also be configured similarly to the server computing device 702, with one or more processors 720, memory 722, instructions 724, and data 726. The user computing device 704 can also include a user input 728 and a user output 730. The user input 728 can include any appropriate mechanism or technique for receiving input from a user, such as keyboard, mouse, mechanical actuators, soft actuators, touchscreens, microphones, and sensors.

The server computing device 702 can be configured to transmit data to the user computing device 704, and the user computing device 704 can be configured to display at least a portion of the received data on a display implemented as part of the user output 730. The user output 730 can also be used for displaying an interface between the user computing device 704 and the server computing device 702. The user output 730 can alternatively or additionally include one or more speakers, transducers, or other audio outputs, a haptic interface or other tactile feedback that provides non-visual and non-audible information to the platform user of the user computing device 704.

Although FIG. 7 illustrates the processors 712, 720 and the memories 714, 722 as being within the computing devices 702, 704, components described in this specification, including the processors 712, 720 and the memories 714, 722 can include multiple processors and memories that can operate in different physical locations and not within the same computing device. For example, some of the instructions 716, 724, and the data 718, 726 can be stored on a removable SD card, and others within a read-only computer chip. Some or all of the instructions and data can be stored in a location physically remote from, yet still accessible by, the processors 712, 720. Similarly, the processors 712, 720 can include a collection of processors that can perform concurrent and/or sequential operations. The computing devices 702, 704 can each include one or more internal clocks providing timing information, which can be used for time measurement for operations and programs run by the computing devices 702, 704.

The server computing device 702 can be configured to receive requests to process data from the user computing device 704. For example, the environment 700 can be part of a computing platform configured to provide a variety of services to users through various user interfaces and/or APIs exposing the platform services. One or more services can be a machine learning framework or a set of tools for generating neural networks or other machine learning models according to a specified task and training data. The user computing device 704 may receive and transmit data specifying target computing resources to be allocated for executing a neural network trained to perform a particular neural network task.

The computing devices 702, 704 can be capable of direct and indirect communication over the network 708. The devices 702, 704 can set up listening sockets that may accept an initiating connection for sending and receiving information. The network 708 itself can include various configurations and protocols including the Internet, World Wide Web, intranets, virtual private networks, wide area networks, local networks, and private networks using communication protocols proprietary to one or more companies. The network 708 can support a variety of short- and long-range connections. The network 708, in addition or alternatively, can also support wired connections between the computing devices 702, 704, including over various types of Ethernet connection.

Although a single server computing device 702 and user computing device 704 are shown in FIG. 7, it is understood that the aspects of the disclosure can be implemented according to a variety of different configurations and quantities of computing devices, including in paradigms for sequential or parallel processing, or over a distributed network of multiple devices. In some implementations, aspects of the disclosure can be performed on a single device, and any combination thereof.

The structure of the IC package and the PCB described herein is beneficial in that it reduces the amount of crosstalk between the vias and reduces the size of both the IC package and the PCB by removing the space needed for ground barriers or additional ground vias.

As used herein, the phrase "at least one of" preceding a series of items, with the terms "and" or "or" to separate any of the items, modifies the list as a whole, rather than each member of the list (i.e., each item). The phrase "at least one of" does not require selection of at least one item; rather, the phrase allows a meaning that includes at least one of any one of the items, and/or at least one of any combination of the items, and/or at least one of each of the items. By way of example, the phrases "at least one of A, B, and C" or "at least one of A, B, or C" each refer to only A, only B, or only C; any combination of A, B, and C; and/or at least one of each of A, B, and C. To the extent that the term "include," "have," or the like is used in the description or the claims, such term is intended to be inclusive in a manner similar to the term "comprise" as "comprise" is interpreted when employed as a transitional word in a claim.

A reference to an element in the singular is not intended to mean "one and only one" unless specifically stated, but rather "one or more." The term "some" refers to one or more. All structural and functional equivalents to the elements of the various configurations described throughout this disclosure that are known or later come to be known to those of ordinary skill in the art are expressly incorporated herein by reference and intended to be encompassed by the subject technology. Moreover, nothing disclosed herein is intended to be dedicated to the public regardless of whether such disclosure is explicitly recited in the above description.

While this specification contains many specifics, these should not be construed as limitations on the scope of what may be claimed, but rather as descriptions of particular implementations of the subject matter. Certain features that are described in this specification in the context of separate implementations can also be implemented in combination in a single implementation. Conversely, various features that are described in the context of a single implementation can also be implemented in multiple implementations separately or in any suitable sub-combination. Moreover, although features may be described above as acting in certain combinations and even initially claimed as such, one or more features from a claimed combination can in some cases be excised from the combination, and the claimed combination may be directed to a sub-combination or variation of a sub-combination.

The subject matter of this specification has been described in terms of particular aspects, but other aspects can be implemented and are within the scope of the following claims. For example, while operations are depicted in the drawings in a particular order, this should not be understood as requiring that such operations be performed in the particular order shown or in sequential order, or that all illustrated operations be performed, to achieve desirable results. The actions recited in the claims can be performed in a different order and still achieve desirable results. As one example, the processes depicted in the accompanying figures do not necessarily require the particular order shown, or sequential order, to achieve desirable results. In certain circumstances, multitasking and parallel processing may be advantageous. Moreover, the separation of various system components in the aspects described above should not be understood as requiring such separation in all aspects, and it should be understood that the described program components and systems can generally be integrated together in a single software product or packaged into multiple software products. Other variations are within the scope of the following claims.

## Claims

1. A printed circuit board (PCB) comprising:
a substrate;
a plurality of layers disposed in the substrate; and
a plurality of vias extending through the plurality of layers connecting two or more layers, wherein each via of the plurality of vias is arranged in a predefined order based on a length of that via, wherein the plurality of vias connect through an interconnect to a set of solder balls on an integrated circuit package.

2. The PCB of claim 1, wherein the plurality of layers facilitate signal transfer between input/output (I/O) devices mounted on the PCB.

3. The PCB of claim 2, wherein each via of the plurality of vias has a counterpart via, wherein the I/O devices mounted on the PCB are configured to communicate through a corresponding layer of the plurality of layers that each via and its counterpart via are configured to reach.

4. The PCB of one of claims 1 to 3, wherein each via of the plurality of vias has a different length; and/or
wherein each via of the plurality of vias is configured to extend through a different number of layers of the plurality of layers.

5. The PCB of one of claims 1 to 4, wherein the plurality of vias include a first via with a longest length configured to be adjacent to a second via with a shortest length.

6. The PCB of claim 5, wherein the plurality of vias include a third via with a second longest length configured to be located farthest from the first via with the longest length.

7. The PCB of one of claims 1 to 6, wherein the plurality of vias does not include ground walls between each other.

8. The PCB of one of claims 1 to 7, wherein the integrated circuit package comprises:
a substrate having a first side and a second side opposite the first side;
an integrated circuit component coupled to the second side of the substrate; and
a ball grid array (BGA) formed on the first side of the substrate, the ball grid array comprising a plurality of solder balls.

9. The PCB of claim 8, wherein the integrated circuit package comprises one or more channels.

10. The PCB of claim 9, wherein each of the one or more channels includes a plurality of sub-channels.

11. The PCB of claim 10, wherein each subchannel of the plurality of sub-channels includes a respective via; and optionally wherein the respective via included in each sub-channel of the plurality of sub-channels has a different length than vias included in other sub-channels.

12. The PCB of claim 10 or claim 11, wherein the one or more channels are separated by an array of solder balls; and
optionally wherein the one or more channels are connected to different layers inside the PCB.

13. A system comprising:
a printed circuit board (PCB) including a plurality of vias extending through a plurality of layers connecting two or more layers, wherein each via of the plurality of vias is arranged in a predefined order based on a length of that via; and
one or more integrated circuit packages connected to the PCB through a plurality of interfaces between a plurality of solder balls included in the one or more integrated circuit packages.

14. The system of claim 13, wherein each via of the plurality of vias is configured to extend through a different number of layers of the plurality of layers; and/or
wherein the plurality of vias does not include ground walls between each other; and/or
wherein the plurality of vias include a first via with a longest length configured to be adjacent to a second via with a shortest length.

15. A method for isolating crosstalk between adjacent vias, the method comprises:
providing a PCB with a plurality of vias;
arranging the plurality of vias in a predefined order based on lengths, wherein the plurality of vias extend through a plurality of layers within the PCB connecting two or more layers, wherein each via of the plurality of vias is arranged in a predefined order based on a length of that via; and
connecting a plurality of devices using the plurality of vias.
